Europäisches Patentamt

European Patent Office

Office européen des brevets

(11) Publication number: **0 273 730 B1**

# EUROPEAN PATENT SPECIFICATION

(45) Date of publication of patent specification: **23.12.92**  (51) Int. Cl.5: **H01S 3/19**, H01S 3/06

(21) Application number: **87311426.8**

(22) Date of filing: **23.12.87**

(54) **Method of fabricating semiconductor laser device.**

(30) Priority: **26.12.86 JP 312015/86**
**23.07.87 JP 183986/87**
**02.11.87 JP 277625/87**

(43) Date of publication of application:
**06.07.88 Bulletin 88/27**

(45) Publication of the grant of the patent:
**23.12.92 Bulletin 92/52**

(84) Designated Contracting States:
**DE FR GB**

(56) References cited:
**US-A- 4 213 805**

**PATENT ABSTRACTS OF JAPAN, vol. 9, no.
159 (E-326)[1882], 4th July 1985; & JP-A-60 37
793 (NIPPON DENKI K.K.) 27-02-1985**

**PATENT ABSTRACTS OF JAPAN, vol. 10, no.
113 (E-399)[2170], 26th April 1986; & JP-A-60
247 985 (NIPPON DENKI K.K.) 07-12-1985**

**PATENT ABSTRACTS OF JAPAN, vol. 8, no.
250 (E-279)[1687], 16th November 1984; & JP-
A-59 126 693 (FUJIKURA DENSEN K.K.)
21-07-1984**

**ELECTRONICS LETTERS, vol. 18, no. 23, 11th
November 1982, pages 1006-1008,
Stevenage, Herts, GB; Y. ITAYA et al.: "New
1.5mum wavelength GaInAsP/InP distributed
feedback laser"**

(73) Proprietor: **MATSUSHITA ELECTRIC INDUSTRI-
AL CO., LTD.
1006, Oaza Kadoma
Kadoma-shi, Osaka-fu, 571(JP)**

(72) Inventor: **Uno, Tomoaki
24-208, 5-ban, 2-chome Tsukuda
Nishiyodogawa-ku Osaka(JP)**
Inventor: **Serizawa, Hiroyuki
1-32-5 Nagao-higashi-machi
Hirakata Osaka(JP)**

(74) Representative: **Crawford, Andrew Birkby et al
A.A. THORNTON & CO. Northumberland
House 303-306 High Holborn
London WC1V 7LE(GB)**

EP 0 273 730 B1

Note: Within nine months from the publication of the mention of the grant of the European patent, any person
may give notice to the European Patent Office of opposition to the European patent granted. Notice of opposition
shall be filed in a written reasoned statement. It shall not be deemed to have been filed until the opposition fee
has been paid (Art. 99(1) European patent convention).

## Description

This invention relates to a method of fabricating a semiconductor laser device, and more particularly to a method of fabricating a semiconductor laser device of a structure having a grating.

Along with the recent development in the optical communication technology using optical fibers as the transmission route, it is attempted to improve the semiconductor device which serves as the light source four high-speed, long-distance signal transmission. As semiconductor laser devices of this type, distributed feedback laser and distributed Bragg reflector having a grating therein are known, and are widely researched and developed. Conventionally, the manufacturing method of the semiconductor laser device as mentioned above of a structure having an optical waveguide layer in the upper part of the laser active layer and also having a grating in the upper part of the optical waveguide layer, i.e., the BH (buried hetero) structure, required a first crystal growth step for sequential epitaxial growth of buffer layer, laser active layer and optical waveguide layer on a semiconductor substrate, a second crystal growth step for epitaxial growth of a clad layer on a grating, a step of forming a stripe-shaped laser cavity structure by selectively etching in a direction vertical to the groove of the grating, and a third crystal growth step for epitaxial growth of two or more current confinement layers around the stripes.

In such conventional manufacturing method, however, the crystal growth method in liquid phase was employed, and thermal deformation of grating and melt-back were serious problems.

For example, Y. Itaya et al. indicated, in Electron. Lett., 1982, 18, pp. 1006 - 1008, that, in fabrication of DFB laser of 1.5 $\mu$m band, the corrugation (grating) of initial depth of 2000 Å decreased to a depth of 500 Å after crystal growth. Similarly, M. Kitamura et al. indicated, in Electron. Comm. Society Technical Research Report OQE83-100 (1983), that, in fabrication of DBF laser of 1.3 $\mu$m band, the corrugation of initial depth of 1500 to 2000 Å decreased to a depth of about 1000 Å after crystal growth. In Fig. 13 of the same report, a threshold current distribution is shown, and large fluctuations in a range of tens of milliamperes are obvious.

The unevenness seems to be derived from thermal deformation of the grating in the wafer and nonuniformity of melt-back, and unevenness in the manufacturing process comprising three steps of crystal growth.

On the other hand, in the vapor phase crystal growth method in the upper part of the grating, the manufacturing method of crystal growth of clad layer was reported by M. Razeghi et al. in Appl.

Phys. Lett. 45 (7), 1 October, 1984. However, its structure may be called as ridge-waveguide structure, which is not comparable with this invention.

Thus, in the fabrication of DH type DFB laser having the grating in the upper part of the active layer, the following problems still remain:

(1) Three steps of crystal growth are required, and the number of steps is many, and the yield of the fabrication process is low.

(2) By the liquid phase crystal growth method, the characteristics become uneven in the wafer due to the thermal deformation of grating and melt-back, and the coupling constant with the grating cannot be taken in a large value.

A method of manufacturing a single axial mode semiconductor laser is disclosed in JP-A-60-37793 (Patent Abstracts of Japan, Vol. 9, No. 159, (E-326) [1882], 4th July 1985). According to the method, an N type buffer layer 2, a non-doped InGaAsP active layer 3 and a P type InGaAsP optical guide layer 4 are laminated on an N type InP substrate 1. Next, grooves 31 and 32 having a depth penetrating through the active layer 3 and parallel with each other are formed, and a P type current block layer 7 is grown on the substrate, forming a mesa stripe 30. A further N type InP current confined layer 8 is also grown except on the upper part of the stripe 30. A P type buried layer 9 is then laminated, and finally a P type InGaAsP cap layer 6, with a P side electrode 71 and an N side electrode 72 being formed on the appropriate sides of the device.

A liquid phase epitaxy method of forming a filamentary laser device is disclosed in US patent 4,213,805. The method includes the steps of forming a first GaAlAs layer on a GaAs body, forming a laser active layer of GaAs on the first GaAlAs layer, etching the first GaAlAs layer and the laser active layer so as to give a mesa shaped structure and to expose the GaAs body, and forming a second GaAlAs layer on said exposed GaAs body and on the surface of the mesa shaped structure so that the mesa etched first GaAlAs layer and the mesa etched active layer are surrounded by the second GaAlAs layer. A diffusion region contacts the GaAs active layer.

It is a primary object of this invention to present a method of fabricating a semiconductor laser device which is capable of solving the above-discussed conventional problems.

This and other objects are accomplished by the present invention, as claimed in claim 1 and, according to alternatives, in claims 2 and 3. Claim 1 provides a method of fabricating a semiconductor laser device, comprising:

a first crystal growth step consisting of forming, in sequence, by liquid-phase epitaxial growth on a compound semiconductor substrate, a first semi-

conductor layer of a first conductivity type as a clad layer, a second semiconductor layer of the first conductivity type as an active layer, and a third semiconductor layer of a second conductivity type as a waveguide layer;

a step for forming a grating by selectively etching the surface of said third semiconductor layer;

a step for forming a stripe-shaped laser cavity structure, by selectively etching a layer extending at least to said first semiconductor layer among said epitaxial growth layers, with a direction of elongation perpendicular to the grooves of said grating;

a second crystal growth step in which a fourth semiconductor layer having a current blocking function is formed on the semiconductor surface by epitaxial vapor-phase crystal growth, said fourth semiconductor layer being composed of, and sequentially formed by, a fifth semiconductor layer of the second conductivity type and a sixth semiconductor layer of the first conductivity type;

a step for forming a diffusion region in which a first impurity of the second conductivity type is diffused from the surface of said sixth semiconductor layer above said laser cavity structure into a region extending at least to said fifth semiconductor layer; and

a step for forming a first electrode in contact with said diffusion region on the surface of said sixth semiconductor layer, and a second electrode in contact with said compound semiconductor substrate,

whereby electric current flowing between said first electrode and said second electrode is blocked by said fourth semiconductor layer and injected into a part of said laser cavity structure for laser oscillation.

In this invention, by employing the vapor phase crystal growth method, the semiconductor layer can be crystally grown on the grating while hardly causing thermal deformation of grating and melt-back, and the current confinement structure can be crystally grown at the same time.

While the novel features of the invention are set forth with particularity in the appended claims, the invention, both as to organization and content, will be better understood and appreciated, along with other objects and features thereof, from the following detailed description taken in conjunction with the drawings.

Figs. 1A through 1F are perspective views showing the method of fabricating a semiconductor laser device in a first embodiment of this invention;

Fig. 2 is a perspective view of the semiconductor laser device manufactured by the method of the first embodiment;

Fig. 3 shows the temperature dependency of the optical output-current characteristics of the semiconductor laser device according to the first embodiment;

Fig. 4 shows the high output characteristics and longitudinal mode spectrum of the semiconductor laser device according to the first embodiment;

Fig. 5 shows the changes in the longitudinal mode spectrum due to current of the semiconductor laser device according to the first embodiment;

Fig. 6 is a histogram of threshold current distribution in pulse current operation of the semiconductor laser device according to the first embodiment;

Fig. 7 is a perspective view of a semiconductor laser device manufactured by the method of a second embodiment of this invention; and

Fig. 8 is a perspective view of a semiconductor laser device manufactured by the method of a third embodiment of this invention.

Detailed Description of the Invention

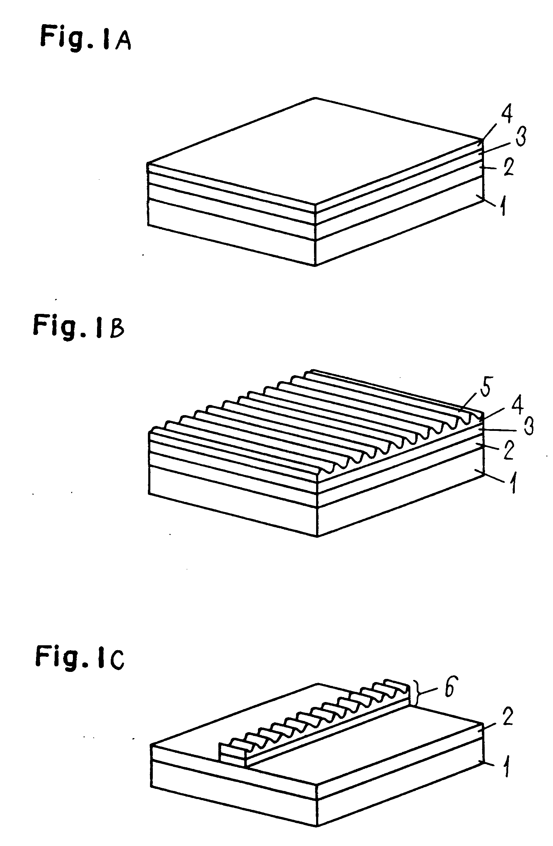

Referring now to Figs. 1A through 1F, a first embodiment of this invention is described herein. The drawings show the sequential steps of method of fabrication of the first embodiment of this invention. This embodiment relates to a method of fabricating a distribution feedback (DFB) type semiconductor laser of InP/InGaAsP compound which is oscillated at a wavelength of 1.3 $\mu$m. In the drawings, numeral 1 is an N type InP substrate (Sn-doped N ~ 3 $\times$ 10$^{18}$ cm$^{-3}$); 2 is an N type InP clad layer (Te-doped, N ~ 1 $\times$ 10$^{18}$ cm$^{-3}$) ; 3 is an N type InGaAsP active layer (undoped, $\lambda$g ~ 1.3 $\mu$m); 4 is a P type InGaAsP waveguide layer (Zn-doped, P ~ 5 $\times$ 10$^{17}$ cm$^{-3}$); 5 is a grating with period of 2000 Å (10 Å = 1 nm); 6 is a laser cavity structure selectively etching the active layer 3 and waveguide layer 4; 7 is a P type InP current confinement layer (Zn-doped, P ~ 1 $\times$ 10$^{18}$cm$^{-3}$); 8 is an N type InP current confinement layer (Te-doped, N ~ 1 $\times$ 10$^{18}$ cm$^{-3}$); 9 is a P type InP clad layer (Zn-doped, P ~ 1 $\times$ 10$^{18}$ cm$^{-3}$) and a P type InGaAsP contact layer (Zn-doped, P ~ 3 $\times$ 10$^{18}$ cm$^{-3}$, $\lambda$g ~ 1.3 $\mu$m); 10 is a Zn-diffused region; 11 is an Au/Sn/Au ohmic electrode; and 12 is an Au/Zn/Au ohmic electrode.

The fabricating method of this DFB type semiconductor laser is described below step by step. Fig. 1A shows the structure after a first crystal growth step of sequentially crystallizing a clad layer 2 as first semiconductor layer, an active layer 3 as second semiconductor layer, and a waveguide layer 4 as third semiconductor layer on a substrate 1 by a conventional liquid phase epitaxial (LPE) method. On the waveguide layer 4, then, a photoresist layer is applied in a thickness of about 1000 Å, and a grating pattern is formed holographically by He-Cd laser (wavelength: 345 nm), and the surface of the waveguide layer 4 is selectively etched according to the grating pattern by using a mixed solution of saturated bromine water and hydrophosphoric acid. After the step of forming the grating by removing the photoresist by organic solvent, the structure shown in Fig. 1B is obtained. On the surface of the waveguide layer 4 on which the grating 5 is formed, a photoresist layer is applied again in a thickness of about 1 $\mu$m, and a stripe pattern in a width of about 2 $\mu$m is formed in the direction vertical to the groove of the grating 5 by the conventional mask exposure method.

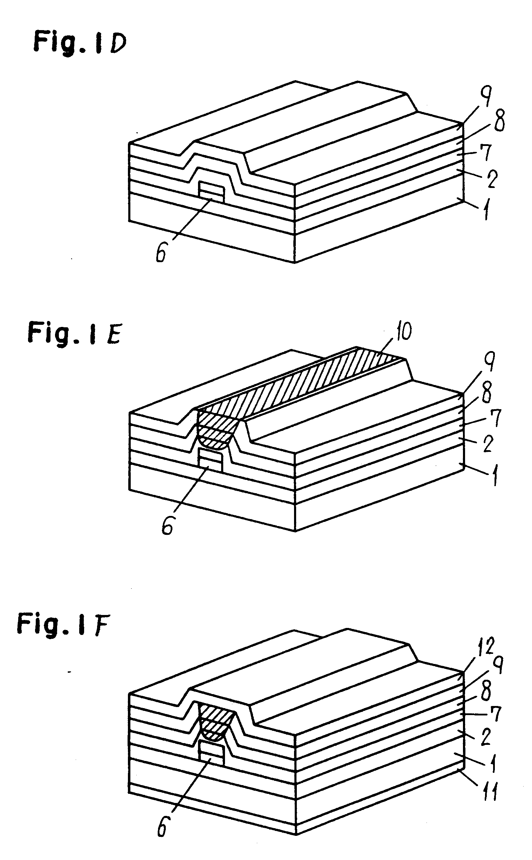

Having this done, the stripe pattern of the photoresist layer is used as the mask for selectively etching the waveguide layer 4 and active layer 3 by using a mixed solution of saturated bromine water and hydrophosphoric acid and a mixed solution of hydrosulfuric acid and hydrogen peroxide water, and the photoresist layer is removed by organic solvent to finish the step of forming the stripe-shaped laser cavity, thereby obtaining the structure as shown in Fig. 1C. Sequentially, by employing the metal organic vapor phase epitaxial (MO-VPE) method which is a conventional crystal growth method in vapor phase, a current confinement layer 7 as a fifth semiconductor layer, a current confinement layer 8 as a sixth semiconductor layer, and a clad layer 9 as a seventh semiconductor layer are sequentially formed crystally, and a second crystal growth step is finished to obtain the structure of Fig. 1D. Next, on the surface of the clad layer 9 in the upper part of the laser cavity structure 6, using a silicon nitride film possessing a stripe opening as the mask, Zn is thermally diffused (500°C, 20 minutes) by the conventional sealing method, and the silicon nitride film is removed by using hydrofluoride acid. The diffusion front of Zn has reached the current confinement layer 7. Zn-diffused area is shown by numeral 10 in Fig. 1E.

This ends the step of diffusing a first impurity, and the structure of Fig. 1E is obtained. In consequence, an ohmic electrode 12 is evaporated on the face of the clad layer 9 and an ohmic electrode 11 on the back of the substrate 1, and after sintering for 5 minutes at 450°C in the hydrogen atmosphere, the structure of Fig. 1F is obtained. Finally, the wafer is split together with the device by cleaving, and the manufacturing process of semiconductor laser device is finished.

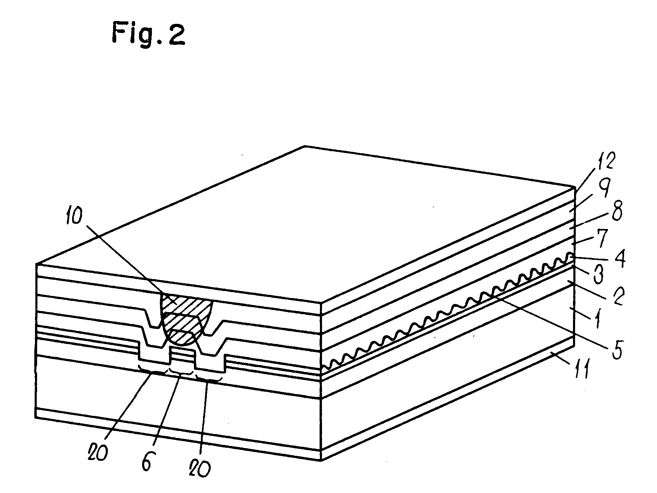

An example of thus obtained structure is shown in Fig. 2. In the explanations to follow, the same parts as mentioned above are given identical code numbers and their descriptions are omitted.

In Fig. 2, numeral 20 denotes etching grooves. Different from Fig. 1F, when a laser cavity structure 6 is formed by two etching grooves 20 possessing a width of about 10 $\mu$m, the surface shape of the device becomes almost flat as shown in Fig. 2, which is convenient for mounting on the package. At this time, the layer structure other than the Zn diffused region 10 is a P-N-P-N conductive type, which has a strong current blocking function, and the current injected from the ohmic electrode 12 into the ohmic electrode 11 is effectively injected into the part of the laser cavity structure 6, thereby contributing to laser resonance.

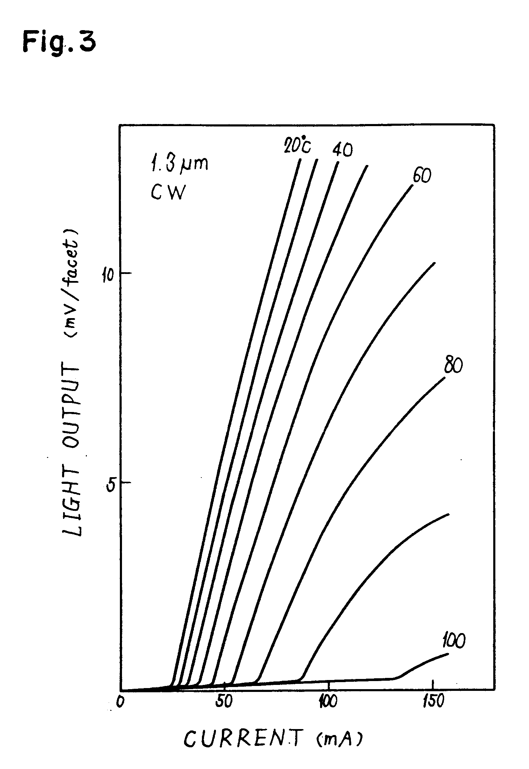

The characteristics of the device obtained by this first embodiment are described by reference to Fig. 3 to Fig. 6.

Fig. 3 shows the temperature dependency of the optical output-current characteristics. At 20°C, the threshold current was about 20 mA, and laser oscillation action of single longitudinal mode could be obtained in a temperature range of over 100°C. The values of characteristic temperature $T_0$ at 20°C to 50°C were as high as 65 K to 70 K.

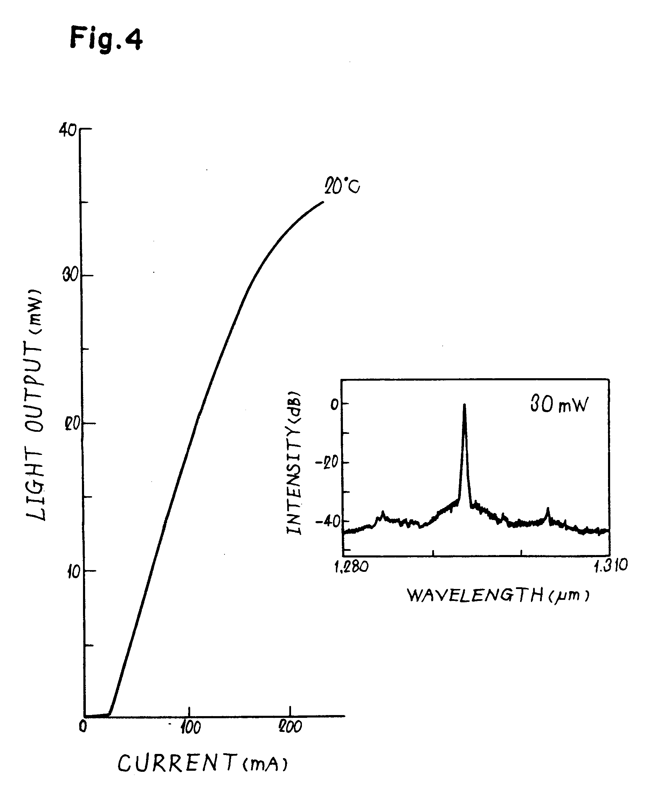

Fig. 4 shows the relation between the high output characteristic and longitudinal mode spectrum. At 20°C, an output of single longitudinal mode spectrum of over 35 mW was obtained by continuous operation. When the optical output was 30 mW, a sub-mode suppression ratio of over 30 dB was obtained from the longitudinal mode spectrum.

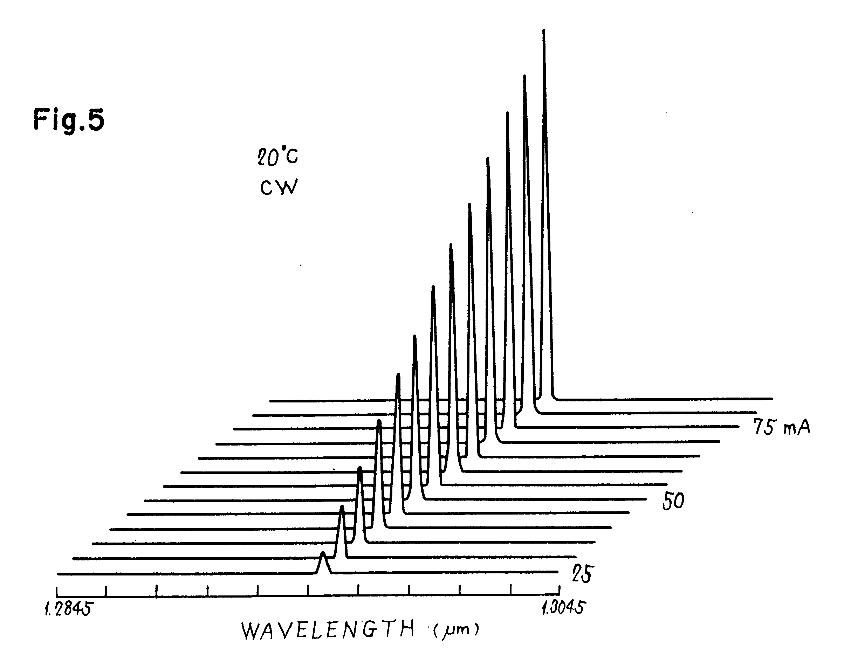

Fig. 5 shows the changes in the longitudinal mode spectrum depending on the current at 20°C. When the current varied, an excellent single longitudinal mode operation was obtained.

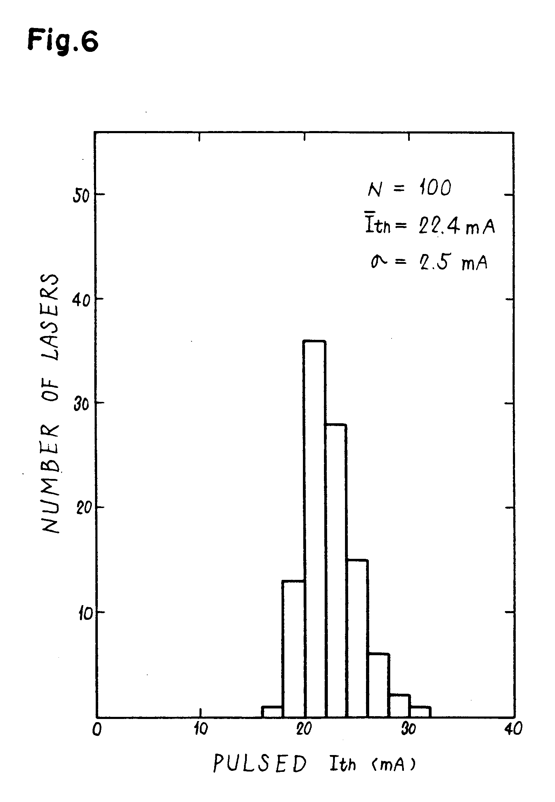

Fig. 6 is a histogram of threshold current distribution under pulse current operation. The mean of the threshold currents of chips selected at random from within a wafer of about 2 cm by 3 cm was 22.4 mA, and the standard deviation was 2.5 mA, and thus characteristics of excellent uniformity were obtained. The efficacy of this invention has been hence confirmed (Proceedings of the 48th Academic Lecture of Japan Society of Applied Physics, 20a-ZR-5, Japan).

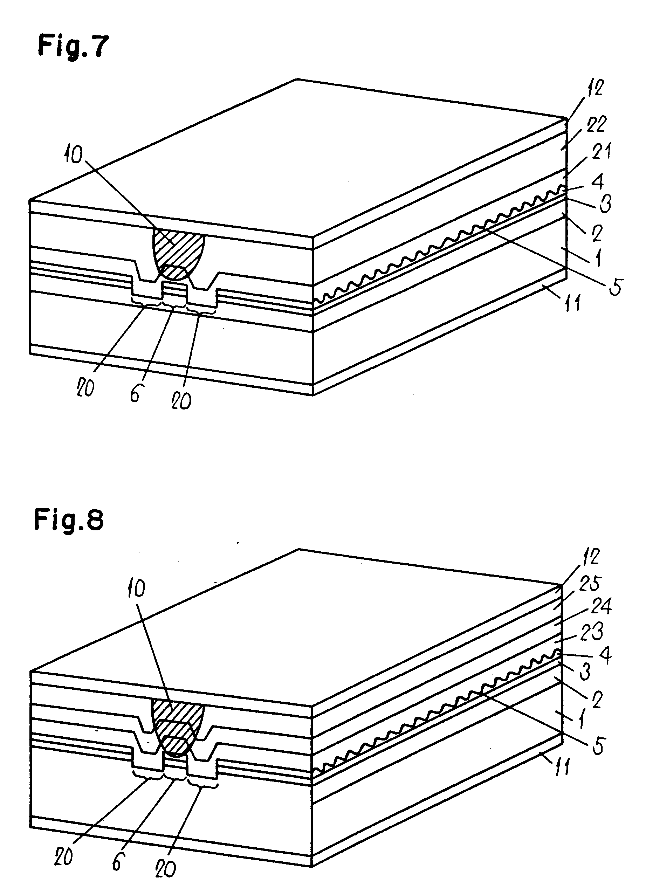

A second embodiment of this invention is described below by referring to Fig. 7. In Fig. 7, numeral 21 is a P type InP current confinement layer, and 22 is an N type InP current confinement layer. The manufacturing method is almost similar to that shown in Fig. 1, differing only in that the part of fourth semiconductor layer is composed of a P type InP current confinement layer as a fifth semiconductor layer and an N type InP current confinement layer as a sixth semiconductor layer.

In this embodiment, too, the layer structure other than the Zn diffused portion is a P-N-P conductive type, which possesses a strong current blocking function, and the current injected from the ohmic electrode 12 into the ohmic electrode 11 is effectively injected into the portion of the laser cavity structure 6, thereby contributing to the laser oscillation.

As the characteristics of this semiconductor laser, an excellent mean value of 26 mA was obtained as the threshold current within the wafer, and the efficacy of this invention has been confirmed.

Referring to Fig. 8, hereinafter, a third embodiment of this invention is described below. In Fig. 8, numeral 23 is a non-doped InP buffer layer, 24 is a conventionally known iron (Fe)-doped semi-insulating InP layer, and 25 is an InGaAsP contact layer. The manufacturing method of almost similar to that shown in Fig. 1, except that the part of the fourth semiconductor layer is composed of the non-doped InP buffer layer 23, the semi-insulating InP layer 24, and the InGaAsP contact layer, and that the Zn diffusion front reaches the P type InGaAsP waveguide layer as the third semiconductor layer.

In this embodiment, too, the layer structure other than the Zn-diffused portion is a combination of semi-insulating-N type, possessing a strong current blocking function, and the current injected from the ohmic electrode 12 into the ohmic electrode 11 is effectively injected into the portion of laser cavity structure 6, thereby effectively contributing to the laser oscillation.

As the characteristics of this semiconductor laser device, an extremely uniform performance was obtained with the mean threshold current of 28 mA in the wafer, and as a result of reduction of capacity of buried region, a flat frequency characteristic of small signal modulation was obtained up to 5 GHz or higher frequency, and the efficacy of this invention has been confirmed.

Thus, the excellent characteristics of the semiconductor laser device in these three embodiments were realized because (1) the storage of grating was improved by employing the vapor phase crystal growth method, (2) the number of steps in manufacturing process has been reduced because the number of crystal growth steps has been reduced to twice, and the yield and uniformity are enhanced, (3) the controllability of active layer width is improved because the etching depth is shallow in the forming step of the laser cavity structure by etching, and (4) by introducing the vapor phase crystal growth method, the uniformity of film thickness, controllability of composition, and crystal growth area have been improved as compared with the conventional liquid phase crystal growth. These are the important effects of this invention.

## Claims

1. A method of fabricating a semiconductor laser device comprising:

a first crystal growth step consisting of forming, in sequence, by liquid-phase epitaxial growth on a compound semiconductor substrate (1), a first semiconductor layer of a first conductivity type as a clad layer (2), a second semiconductor layer of the first conductivity type as an active layer (3), and a third semiconductor layer of a second conductivity type as a waveguide layer (4);

a step for forming a grating (5) by selectively etching the surface of said third semiconductor layer;

a step or forming a stripe-shaped laser cavity structure (6), by selectively etching extending at least to said first semiconductor layer among said epitaxial growth layers, with a direction of elongation perpendicular to the grooves of said grating;

a second crystal growth step in which a fourth semiconductor layer having a current blocking function is formed on the semiconductor surface by epitaxial vapor-phase crystal growth, said fourth semiconductor layer being composed of, and sequentially formed by, a fifth semiconductor layer (21) of the second conductivity type and a sixth semiconductor layer (22) of the first conductivity type;

a step for forming a diffusion region (10) in which a first impurity of the second conductivity type is diffused from the surface of said sixth semiconductor layer above said laser cavity structure into a region extending at least to said fifth semiconductor layer; and

a step for forming a first electrode (12) in contact with said diffusion region on the surface of said sixth semiconductor layer, and a second electrode (11) in contact with said compound semiconductor substrate, whereby electric current flowing between said first electrode and said second electrode is blocked by said fourth semiconductor layer and injected into a part of said laser cavity structure for laser oscillation.

2. A method according to claim 1, wherein:

in said second crystal growth step for forming the fourth semiconductor layer by vapor-phase expitaxial growth, said fourth semiconductor layer is composed of, and sequentially formed by, the fifth semiconductor layer (7) of the second conductivity type, the sixth semiconductor layer (8) of the first conductivity type and, as an alternative to claim 1, a seventh semiconductor layer (9) of the second conductivity type, being composed of at least one layer, and the diffusion region (10) is formed between the surface of said seventh semiconductor layer and at least said fifth semiconductor layer.

3. A method according to claim 1, wherein, as an alternative to claim 1, said fourth semiconductor layer is composed of, and sequentially formed by, a non-doped buffer layer (23) for restricting automatic doping, and a further semiconductor layer consisting of at least a layer (24) possessing semi-insulating properties, and said diffusion region (10) is formed between the surface of said further semiconductor layer and said waveguide layer (4).

4. A method according to claim 1, wherein said first semi-conductor layer is an InP compound semiconductor layer, said second and third semiconductor layers are InGaAsP compound semiconductor layers differing in composition, with the band gap energy of the second semiconductor layer being lower than that of the third semiconductor layer, and said fourth semiconductor layer is a compound semiconductor layer composed of InP, or InGaAsP, or InP and InGaAsP.

5. A method according to any of the preceding claims, wherein said first conductivity type is N type, said second conductivity type is P type, and said first impurity is either Zn or Cd.

6. A method according to any of the preceding claims, wherein said semiconductor laser device is of the distributed feedback type.

**Patentansprüche**

1. Verfahren zur Herstellung einer Halbleiter-Laservorrichtung umfassend:
einen ersten Kristallwachstumsschritt, der durch Flüssigphasenepitaxie auf einem Verbundhalbleitersubstrat (1) in Aufeinanderfolge eine erste Halbleiterschicht eines ersten Leitfähigkeitstyps als eine Plattierungsschicht (2), eine zweite Halbleiterschicht des ersten Leitfähigkeitstyps als eine Aktivschicht (3), und eine dritte Halbleiterschicht eines zweiten Leitfähigkeitstyps als einen Wellenleiterschicht (4) bildet;
einen Schritt zur Bildung eines Beugungsgitters (5) durch selektive Ätzung der Oberfläche der dritten Halbleiterschicht;
einen Schritt zur Bildung einer streifenförmigen Laserhohlraumstruktur (6) durch selektive Ätzung, die sich mindestens bis zu der ersten Halbleiterschicht unter den Epitaxieschichten erstreckt, mit einer Richtung in Verlängerung senkrecht zu den Rillen des Beugungsgitters;
einen zweiten Kristallwachstumsschritt, in dem eine vierte Halbleiterschicht mit einer Stromsperrfunktion auf der Halbleiteroberfläche durch epitaktisches Dampfphasenkristallwachstum gebildet wird, die vierte Halbleiterschicht zusammengesetzt und aufeinanderfolgend gebildet wird durch eine fünfte Halbleiterschicht (21) des zweiten Leitfähigkeitstyps und einer sechsten Halbleiterschicht (22) des ersten Leitfähigkeitstyps;
einen Schritt zur Bildung eines Diffusionsbereiches (10), in dem eine erste Verunreinigung des zweiten Leitfählgkeitstyps von der Oberfläche der sechsten Halbleiterschicht oberhalb der Laserhohlraumstruktur in einen Bereich diffundiert wird, der sich mindestens bis zu der fünften Halbleiterschicht erstreckt; und
einen Schritt zur Bildung einer ersten Elektrode (12) in Kontakt mit dem Diffusionsbereich auf der Oberfläche der sechsten Halbleiterschicht, und einer zweiten Elektrode (11) in Kontakt mit dem Verbundhalbleitersubstrat,
wodurch der zwischen der ersten Elektrode und der zweiten Elektrode fließende elektrische Strom durch die vierte Halbleiterschicht gesperrt wird und in einen Teil der Laserhohlraumstruktur zur Laserschwingung injiziert wird.

2. Verfahren nach Anspruch 1, worin in dem zweiten Kristallwachstunmsschritt zur Bildung der vierten Halbleiterschicht durch Dampfphasenepitaxie die vierte Halbleiterschicht zusammengesetzt und aufeinanderfolgend gebildet wird durch die fünfte Halbleiterschicht (7) des zweiten Leitfähigkeitstyps, die sechste Halbleiterschicht (8) des ersten Leitfähigkeitstyps und, als Alternative zu Anspruch 1, eine siebte Halbleiterschicht (9) des zweiten Leitfähigkeitstyps, die zusammengesetzt ist aus mindestens einer Schicht, und der Diffusionsbereich (10) wird gebildet zwischen der Oberfläche der siebten Halbleiterschicht und mindestens der fünften Halbleiterschicht.

3. Verfahren nach Anspruch 1, worin, als eine Alternative zu Anspruch 1, die vierte Halbleiterschicht zusammengesetzt und aufeinanderfolgend gebildet wird durch eine undotierte Pufferschicht (23) zur Einschränkung automatischer Dotierung, und weiterer Halbleiterschicht bestehend aus mindestens einer Schicht (24), die halbisolierende Eigenschaften besitzt, und der Diffusionsbereich (10) wird gebildet zwischen der Oberfläche der weiteren Halbleiterschicht und der Wellenleiterschicht (4).

4. Verfahren nach Anspruch 1, worin die erste Halbleiterschicht eine InP Verbundhalbleiterschicht ist, die zweite und dritte Halbleiterschichten InGaAsP Verbundhalblelterschichten unterschiedlicher Zusammensetzung sind, mit der Bandlückenenergie der zweiten Halbleiterschicht, die niedriger ist als die der dritten Halbleiterschicht, und die vierte Halbleiterschicht eine Verbundhalbleiterschicht ist, die aus InP, oder InGaAsP, oder InP und InGaAsP zusammengesetzt ist.

5. Verfahren nach einem der vorangehenden Ansprüche, worin der erste Leitfähigkeitstyp ein N-Typ, der zweite Leitfähigkeitstyp ein P-Typ, und die erste Verunreinigung entweder Zn oder Cd ist.

6. Verfahren nach einem der vorangehenden Ansprüche, worin die Halbleiter-Laservorrichtung vom Typ mit verteilter Rückkopplung ist.

**Revendications**

1. Procédé de fabrication d'un dispositif laser à semi-conducteur, comprenant :

une première étape de croissance de cristal consistant en la formation, sur un substrat semiconducteur composé (1), en séquence, par croissance épitaxiale en phase liquide, d'une première couche semi-conductrice d'un premier type de conductivité comme couche plaquée (2), d'une seconde couche semi-conductrice du premier type de conductivité comme couche active, (3), et d'une troisième couche semi-conductrice d'un second type de conductivité comme couche guide d'ondes (4) ;

une étape de formation d'une grille (5) en gravant de manière sélective la surface de ladite troisième couche semi-conductrice ;

une étape de formation d'une structure de cavité laser en forme de bande (6), en gravant de manière sélective une couche s'étendant au moins jusqu'à ladite première couche conductrice desdites couches produites par croissance épitaxiale, avec une direction longitudinale perpendiculaire aux rainures de ladite grille ;

une seconde étape de croissance de cristal dans laquelle une quatrième couche semi-conductrice ayant une fonction de blocage de courant est formée sur la surface semi-conductrice par croissance épitaxiale de cristal en phase vapeur, ladite quatrième couche semi-conductrice étant composée de, et formée séquentiellement par, une cinquième couche semi-conductrice (21) du second type de conductivité et une sixième couche semi-conductrice (22) du premier type de conductivité ;

une étape de formation d'une région de diffusion (10) dans laquelle une première impureté du second type de conductivité est diffusée à partir de la surface de ladite sixième couche semi-conductrice au-dessus de ladite structure de cavité de laser dans une région s'étendant au moins jusqu'à ladite cinquième couche semi-conductrice ; et

une étape de formation d'une première électrode (12) en contact avec ladite région de diffusion sur la surface de ladite sixième couche semi-conductrice, et d'une seconde électrode (11) en contact avec ledit substrat semi-conducteur composé,

ce par quoi le courant électrique s'écoulant entre ladite première électrode et ladite seconde électrode est bloqué par ladite quatrième couche semi-conductrice et injecté dans une partie de ladite structure de cavité laser pour oscillation laser.

2. Procédé selon la revendication 1, dans lequel :

dans ladite seconde étape de croissance de cristal pour former la quatrième couche semi-conductrice par croissance épitaxiale en phase vapeur, ladite quatrième couche semi-conductrice est composée de, et formée séquentiellement par, la cinquième couche semi-conductrice (7) du second type de conductivité, la sixième couche semi-conductrice (8) du premier type de conductivité, et comme variante par rapport à la revendication 1, une septième couche semi-conductrice (9) du second type de conductivité qui est composée d'au moins une couche, et dans lequel la région de diffusion (10) est formé entre la surface de ladite septième couche semi-conductrice et au moins ladite cinquième couche semi-conductrice.

3. Procédé selon la revendication 1, dans lequel, comme variante par rapport à la revendication 1, ladite quatrième couche semi-conductrice est composée de, et formée séquentiellement par, une couche tampon non dopée (23) pour limiter le dopage automatique, et en outre d'une couche conductrice supplémentaire constituée d'au moins une couche (24) possédant des propriétés semi-isolantes, et dans lequel ladite région de diffusion (10) est formée entre la surface de ladite couche semi-conductrice supplémentaire et ladite couche guide d'ondes (4).

4. Procédé selon la revendication 1, dans lequel ladite première couche semi-conductrice est une couche semi-conductrice d'un composé de InP, lesdites deuxième et troisième couches semi-conductrices sont des couches semi-conductrices de composés de InGaAsP, différentes en composition, l'énergie de largeur de bande interdite de la deuxième couche semi-conductrice étant inférieure à celle de la troisième couche semi-conductrice, et dans lequel ladite quatrième couche semi-conductrice est une couche de composé semi-conducteur, composé de InP ou InGaAsP ou InP et In-GaAsP.

5. Procédé selon l'une quelconque des revendications précédentes, dans lequel ledit premier type de conductivité est le type N, et ledit second type de conductivité est le type P, et ladite première impureté est soit Zn, soit Cd.

6. Procédé selon l'une quelconque des revendications précédentes, dans lequel le dispositif laser à semi-conducteur est du type à contre-réaction à constantes réparties.

**Fig.1**A

**Fig.1**B

**Fig.1**C

## Fig. 1 D

## Fig. 1 E

## Fig. 1 F

# Fig.2

# Fig.3

# Fig.4

**Fig.5**

20°C
CW

75 mA

50

25

1.2845                    1.3045

WAVELENGTH (μm)

EP 0 273 730 B1

# Fig.6

PULSED Ith (mA)

NUMBER OF LASERS

N = 100

$\overline{I}_{th}$ = 22.4 mA

$\sigma$ = 2.5 mA

# Fig.7

# Fig.8